# EUROPÄISCHE PATENTSCHRIFT

(11) **EP 2 183 797 B1**
(45) Veröffentlichungstag und Bekanntmachung des Hinweises auf die Patenterteilung: **02.03.2011**
(21) Anmeldenummer: 08801146.5
(22) Anmeldetag: 08.08.2008
(51) Int. Cl.: H01L 51/44, H01L 51/46

(54) **PASSIVIERUNGSSCHICHT FÜR EINE TRANSPARENTE LEITFÄHIGE OXIDSCHICHT IN EINEM BAUELEMENT MIT ORGANISCHER AKTIVER SCHICHT**
PASSIVATION LAYER FOR A TRANSPARENT CONDUCTIVE OXIDE LAYER IN A COMPONENT WITH ORGANIC ACTIVE LAYER
COUCHE DE PASSIVATION POUR UNE COUCHE D'OXYDE CONDUCTRICE TRANSPARENTE DANS UN ÉLÉMENT DOTÉ D'UNE COUCHE ACTIVE ORGANIQUE

(30) Priorität: 11.08.2007 DE 102007037945
(43) Veröffentlichungstag der Anmeldung: 12.05.2010
(73) Patentinhaber: Helmholtz-Zentrum Berlin für Materialien und Energie GmbH, 14109 Berlin (DE)
(72) Erfinder: JOHNEV, Boyan, 91077 Neunkirchen (DE); FOSTIROPOULOS, Konstantinos, 14197 Berlin (DE)
(86) Internationale Anmeldenummer: PCT/DE2008/001314
(87) Internationale Veröffentlichungsnummer: WO 2009/021495

(56) Entgegenhaltungen:
- WO-A-99/03868
- NAZEERUDDIN ET AL: "Efficient near IR sensitization of nanocrystalline TiO2 films by ruthenium phthalocyanines" JOURNAL OF THE CHEMICAL SOCIETY, CHEMICAL SOCIETY. LETCHWORTH.; GB, 1. Januar 1998 (1998-01-01), XP002075709 ISSN: 0368-1769
- OZOEMENA K I ET AL: "Surface electrochemistry of iron phthalocyanine axially ligated to 4-mercaptopyridine self-assembled monolayers at gold electrode: Applications to electrocatalytic oxidation and detection of thiocyanate" JOURNAL OF ELECTROANALYTICAL CHEMISTRY AND INTERFACIALELECTROCHEMISTRY, ELSEVIER, AMSTERDAM, NL, Bd. 579, Nr. 2, 1. Juni 2005 (2005-06-01), Seiten 283-289, XP004887048 ISSN: 0022-0728
- JOHNEV BOYAN: "Chemical enigineering of the electronic properties of ITO-organics interface in Phthalocyanine/C60-Fullerene organic solar cells"[Online] 5. September 2006 (2006-09-05), XP002507701 Gefunden im Internet: URL:http://www.diss.fu-berlin.de/diss/rece ive/FUDISS_thesis_000000001890> [gefunden am 2008-12-11] in der Anmeldung erwähnt

## Beschreibung

Die Erfindung bezieht sich auf eine Passivierungsschicht für eine transparente leitfähige Oxidschicht in einem Bauelement mit organischer aktiver Schicht, aufweisend eine Monolage aus aromatischen Molekülen mit Dipolmoment.

Ein Schichtsystem aus transparenter leitfähiger Oxidschicht und chemischer Passivierungsschicht findet beispielsweise Anwendung in organischen Solarzellen. Hier wird eine Verbesserung der elektrischen Eigenschaften an der Grenzfläche zwischen der anorganischen transparenten leitenden Oxidschicht (TCO-Schicht) und der organischen Absorberschicht dadurch realisiert, dass zwischen den beiden vorher genannten Schichten üblicherweise zusätzliche Pufferschichten angeordnet sind. Diese Pufferschichten sollen die elektrischen Eigenschaften an der Grenzfläche dadurch verbessern, dass die jeweiligen Energiebänder angepasst und die Traps chemisch passiviert werden.

Eine derartiges Schichtsystem ist z. B. in Appl. Phys. Lett., Vol. 79, No. 1, 2. July 2001, 126 - 128 beschrieben. Die dort beschriebene Solarzelle basiert auf einer CuPc-Donator-Teilschicht und einer C₆₀-Akzeptor-Teilschicht für die photoaktive Schicht (bilayer donor-acceptor device). Eine PEDOT:PSS-Pufferschicht ist zwischen der ITO-Schicht (Anode) und der CuPc-Teilschicht angeordnet, um eine bessere Anpassung des Fermi-Niveaus der ITO-Schicht an das HOMO-Niveau der CuPc-Schicht zu erreichen. Die BCP-Pufferschicht sichert den Transport der Elektronen von der C₆₀-Schicht zur Al-Kathode, blockiert den Transport der Excitonen zur Kathode und verhindert damit die Rekombination.

Auch in "Organic solar cells: An overview" J. Mater. Res., Vol. 19, No. 7, Jul 2004, 1924-1945 wird insbesondere im Abschnitt VII. A. (1. und 2. Absatz sowie Fig. 14) eine solche Pufferschicht zur Verbesserung der Performance der Solarzelle beschrieben.

Eine andere Lösung zur Anpassung der jeweiligen Bänder von TCO-Schicht und organischer Schicht und der chemischen Passivierung der Traps in der Grenzfläche wird in DE 103 07 772 A1 vorgestellt. Hier ist eine Solarzelle beschrieben, bei der auf der ersten transparenten anorganischen Elektrode eine Monolage aus Rest-lonen einer anorganischen Säure oder aus einer Monolage einer niedermolekularen Substanz aus der Gruppe der Phenole, Alkohole oder organischen Säuren angeordnet ist.

Der Stand der Technik, von dem die Erfindung ausgeht, wurde von Johnev in der Dissertation "Chemical engineering of the electronic properties of ITO-organics interface in Phthatocyanine/C₆₀-Fullerene organic solar cells", FU Berlin, verteidigt Februar 2006 (s. insbesondere Zusammenfassunghttp://www.diss.fu-berlin.de/2006/104/) ein Material aus aromatische Molekülen mit Oberflächendipol, nämlich ZnPc4P - Zink-Phthalozyanintetraphosphonische Säure, vorgeschlagen und untersucht. Mit der Passivierung einer ITO-Schicht mit dem genannten Material, das eine Monolage aus aromatischen Molekülen mit Dipolmoment auf der ITO-Oberfläche bildet, konnte zwar eine Erhöhung der elektrischen Leitfähigkeit senkrecht zur ITO-Oberfläche beobachtet werden, die jedoch dadurch begrenzt ist, dass sich ZnPc4P-Moleküle tendeziell senkrecht zur ITO-Oberfläche anordnen und die Leitfähigkeit ungünstigerweise parallel zu ihr verläuft.

Aufgabe der Erfindung ist es deshalb, eine Passivierungsschicht für TCO-Schichten anzugeben, die eine - im Vergleich zum Stand der Technik - noch weiter verbesserte Leitfähigkeit der organischen Schicht senkrecht zur TCO-Schicht gewährleistet.

Die Aufgabe wird durch eine Passivierungsschicht der eingangs genannten Art dadurch gelöst, dass erfindungsgemäß die die Monolage bildenden aromatischen Moleküle Moleküle von axial substituiertem Metall-Phthalozyanin mit Säuregruppe sind, wobei der Metallbestandteil mindestens dreivalent ist, und der aromatische Teil der Moleküle parallel zur Oberfläche der Oxidschicht angeordnet ist.

In einer Ausführungsform ist vorgesehen, dass die Säuregruppen organische Säuregruppen sind, vorzugsweise mindestens eine Hydroxylgruppenhaltige organische Säure (-COOH) aufweist.

In einer anderen Ausführungsform sind die Säuregruppen anorganische Säuregruppen, vorzugsweise Phosphonsäuregruppen (-PO₃H₂).

In weiteren Ausführungsformen ist der Metallbestandteil der Moleküle von axial substituiertem Metall-Phthatozyanin mit Säuregruppe Eisen oder Zinn.

Wird eine TCO-Schicht mit dem erfindungsgemäßen Material chemisch passiviert, dann wird die anschließend aufgebrachte organische Schicht anfänglich parallel zu dieser Monolage wachsen, weil die Haftung zwischen den beiden flächige π-Systeme bildenden Materialien sehr hoch ist. Somit kann durch die gezielt gerichtete Anlagerung der erfindungsgemäßen Passivierungsschicht, nämlich parallele Anordnung des aromatischen Teils der Moleküle zur Oberfläche der TCO-Schicht, die elektrische Leitfähigkeit der organischen Schicht senkrecht zum TCO-Kontakt weiter erhöht werden. Der mindestens dreivalente Metallbestandteil des axial substituierten Metall-Phthalozyanins erlaubt eine axiale Bindung mit der Säuregruppe.

Die Erfindung wird in zwei Ausführungsbeispielen anhand von Figuren näher erläutert.

Dabei zeigen:
- Fig. 1: ein Molekül von Eisen-Phthalozyanin mit einem anorganischen Säurerest;
- Fig. 2: ein Molekül von Eisen-Phthalozyanin mit einem organischen Säurerest.

Das Material für die Passivierungsschicht, nämlich Moleküle von axial substituiertem Metall-Phthalozyanin mit Säuregruppe, wobei der Metallbestandteil mindestens dreivalent ist, wird durch chemische Reaktion von Metall-Phthalozyaninchlorid/en mit einem Säurerest hergestellt. Dieses Herstellungsverfahren ist beispielsweise in Journal of Alloys and Compounds 380 (2004) 186-190 beschrieben.

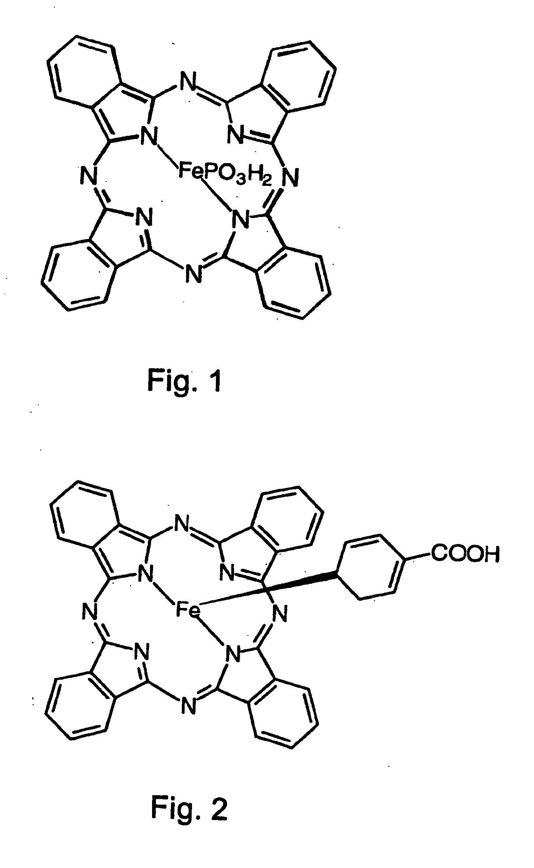

Das in Fig. 1 gezeigte Molekül ist ein Molekül des Eisen (III) Phthalozyaninaxial-Phosphonsäure. Die Säuregruppe, hier die anorganische Säuregruppe -PO₃H₂, steht senkrecht zum aromatischen Teil des gezeigten Moleküls.

Auch im zweiten Beispiel für ein eine Monolage bildendes Molekül von axial substituiertem Metall-Phthalozyanin mit Säuregruppe, nämlich Eisen (III) - Phthalozyanin-axial-para-Hydroxybenzolsäure, dargestellt in Fig. 2, steht der organische Säurerest -COOH senkrecht zum aromatischen Teil des Moleküls.

Diese beiden schematisch dargestellten Moleküle sowie auch die anderen unter den Erfindungsgegenstand fallenden Moleküle von axial substituiertem mindestens dreivalentem Metall-Phthalozyanin mit Säuregruppe können von ihrer Form her wie ein "Schirm" beschrieben werden, dessen "Griff" aus einem organischen oder anorganischen Säurerest besteht und die flache "Schirmfläche" aus dem aromatischen Teil des Moleküls gebildet ist.

Wird nun die zu passivierende TCO-Schicht bei Raumtemperatur in eine gesättigte Lösung von Molekülen, gebildet von axial substituiertem Metall-Phthalozyanin mit Säuregruppe, wobei der Metallbestandteil mindestens dreivalent ist, eingetaucht, wird das Material über die Säuregruppe an die TCO-Schicht gebunden und stellt eine aromatische Terminierung der TCO-Oberfläche in der oben beschriebenen Form her.

Das Aufbringen der erfindungsgemäßen Passivierungsschicht kann auch mittels Aufschleudem erfolgen.

Auf die terminierte TCO-Schicht wird nun ein organisches Material mittels bekannter Mehoden, beispielsweise mittels Aufdampfen, aufgebracht, das - wie bereits beschrieben - zunächst parallel zu dieser Monolage zu wachsen beginnt. Eine weitere Verbesserung der elektrischen Leitfähigkeit der organischen Schicht senkrecht zur TCO-Schicht im Vergleich zum Stand der Technik ist hierbei die Folge.

## Patentansprüche

1. Passivierungsschicht für eine transparente leitfähige Oxidschicht in einem Bauelement mit organischer aktiver Schicht, aufweisend eine Monolage aus aromatischen Molekülen mit Dipolmoment,
**dadurch gekennzeichnet, dass**
die die Monolage bildenden aromatischen Moleküle Moleküle von axial substituiertem Metall-Phthalozyanin mit Säuregruppe sind, wobei der Metallbestandteil mindestens dreivalent ist, und
der aromatische Teil der Moleküle parallel zur Oberfläche der Oxidschicht angeordnet ist.

2. Passivierungsschicht nach Anspruch 1,
**dadurch gekennzeichnet, dass**
die Säuregruppen organische Säuregruppen sind.

3. Passivierungsschicht nach Anspruch 2,
**dadurch gekennzeichnet, dass**
die organische Säuregruppe mindestens eine Hydroxylgruppenhaltige organische Säure aufweist.

4. Passivierungsschicht nach Anspruch 1,
**dadurch gekennzeichnet, dass**
die Säuregruppen anorganische Säuregruppen sind.

5. Passivierungsschicht nach Anspruch 4,
**dadurch gekennzeichnet, dass**
die anorganische Säuregruppe aus Phosphonsäuregruppe gebildet ist.

6. Passivierungsschicht nach Anspruch 1,
**dadurch gekennzeichnet, dass**
der mindestens dreivalente Metallbestandteil Eisen ist.

7. Passivierungsschicht nach Anspruch 1,
**dadurch gekennzeichnet, dass**
der mindestens dreivalente Metallbestandteil Zinn ist.

## Claims

1. A passivation layer for a transparent, conductive oxide layer in a component with an organic active layer, having a monolayer of aromatic molecules with dipole moment,
**characterized in that**
the aromatic molecules that form the monolayer are molecules of axially substituted metal phthalocyoanine with an acid group, wherein the metal component is at least trivalent, and the aromatic portion of the molecules is arranged parallel to the surface of the oxide layer.

2. The passivation layer as recited in claim 1,
**characterized in that**
the acid groups are organic acid groups.

3. The passivation layer as recited in claim 2,
**characterized in that**
the organic acid group includes at least one organic acid that contains a hydroxyl group.

4. The passivation layer as recited in claim 1,
**characterized in that**
the acid groups are inorganic acid groups.

5. The passivation layer as recited in claim 4,
**characterized in that**
the inorganic acid group is formed from the phosphonic acid group.

6. The passivation layer as recited in claim 1,
**characterized in that**
the at least trivalent metal component is iron.

7. The passivation layer as recited in claim 1,
**characterized in that**
the at least trivalent metal component is tin.

## Revendications

1. Couche de passivation pour une couche d'oxyde transparente conductrice dans un composant avec une couche organique active, comportant une monocouche en molécules aromatiques avec moment dipolaire, **caractérisée en ce que** les molécules aromatiques formant la monocouche sont des molécules de phtalocyanines métalliques substituées axialement avec des groupes d'acides, le constituant métallique étant au moins trivalent et la partie aromatique de la molécule étant disposée à la parallèle de la couche d'oxyde.

2. Couche de passivation selon la revendication 1, **caractérisée en ce que** les groupes d'acides sont des groupes d'acides organiques.

3. Couche de passivation selon la revendication 2, **caractérisée en ce que** le groupe d'acides organiques comporte au moins un acide organique contenant un groupe hydroxyle.

4. Couche de passivation selon la revendication 1, **caractérisée en ce que** les groupes d'acides sont des groupes d'acides anorganiques.

5. Couche de passivation selon la revendication 4, **caractérisée en ce que** le groupe d'acides anorganiques est formé d'un groupe d'acide phosphorique.

6. Couche de passivation selon la revendication 1, **caractérisée en ce que** le constituant métallique au moins trivalent est du fer.

7. Couche de passivation selon la revendication 1, **caractérisée en ce que** le constituant métallique au moins trivalent est de l'étain.
